# EUROPÄISCHE PATENTANMELDUNG

(11) **EP 0 902 296 A1**
(43) Veröffentlichungstag der Anmeldung: **17.03.1999**
(21) Anmeldenummer: 97810646.6
(22) Anmeldetag: 11.09.1997
(51) Int. Cl.: G01R 31/28, G01R 1/073, G01R 31/02

(54) **Adapteranordnungen zum Testen von Leiterplatten**

(71) Anmelder: Photo Print Electronic GmbH, 79650 Schopfheim (DE)
(72) Erfinder: Kersten, Peter, Dipl.-Ing., D-79689 Maulburg (DE)
(74) Vertreter: Morstadt, Volker, Dipl.-Ing.

(57) **Zusammenfassung**

Diese Adapteranordnung (3, 5, 6) ist eine zum Testen von, insb. auch großflächigen, Leiterplatten (1, 1') geeignet, deren n Testpunkte (211 ... 281) nur einen Abstand von etwa 150 µm haben. Die Adapteranordnung umfaßt eine einschichtige flexible Folie (30) aus Isoliermaterial und n elektrisch leitende Kontaktbumps (311 ... 381) mit einem Kontaktierungsteil (3111) und einer Längsachse (3112). Der Kontaktbump führt durch die Folie von deren Rückseite zu deren Vorderseite (31) in einer Bohrung (33), die eine Mittelachse (330) hat, senkrecht hindurch. Der Kontaktbump überragt die Vorderseite einstufig und sitzt derart in der Bohrung, daß die Längsachse mit der Mittelachse zusammenfällt. Der Kontaktbump (311) ist auf der Rückseite der Folie mit einem dort verlaufenden Leiterzug (411) kontaktiert, der mit einem ersten Kontaktelement einer Steckverbindung (4) zum Anschluß an das Testgerät dauernd verbunden ist. Während des Testens wird jeder Kontaktbump mit dem zugehörigen Testpunkt durch flächiges Andrücken der Folie (30) an die Leiterplatte (1), wobei eine elektrisch isolierende, elastisch federnde Zwischenfolie (34) an der Rückseite der Folie angeordnet wird, mechanisch in Berührung gebracht und dadurch elektrisch kontaktiert. Anstatt daß jeder Leiterzug der Folie zu der Steckverbindung führt, können die Leiterzüge auch zu Kontaktpunkten (511 - Fig. 5) führen, die mit Kontaktelementen eines Eingangskontaktfelds des Testgeräts zu verbinden sind.

## Beschreibung

Die Erfindung betrifft Adapteranordnungen zum Testen von mindestens einlagigen, unbestückten Leiterplatten.

Nach der Herstellung dieser Leiterplatten, also wenn deren Leiterbahnen fertiggestellt wurden, ist es erforderlich, jede dieser Leiterplatten mindestens in zweierlei Hinsicht elektrisch zu testen. Einerseits ist zu testen, ob Leiterbahnen, die voneinander isoliert sein sollen, auch voneinander isoliert sind und nicht einen unzulässig niederen Isolationswiderstand gegeneinander aufweisen, insb. kurzgeschlossen sind. Andererseits ist zu testen, ob die einzelnen Leiterbahnen auf ihrem Verlauf auch leitend sind und nicht einen unzulässig hohen Widerstand haben, insb. ob sie unterbrochen sind.

Das Testen nach dem Herstellen ist auch in der Halbleiter-Technik üblich und erforderlich, die mit der Technik der Herstellung von Leiterplatten, wenn überhaupt, nur wenig gemeinsam hat. So werden bekanntlich in einem Silicium-Wafer nach der Planartechnik eine Vielzahl von einzelnen integrierten Schaltungen (= Einzel-ICs; im Englischen als "dice" - Singular "die" - bezeichnet) dadurch erzeugt, daß im Bereich des jeweiligen Einzel-ICs an seiner Oberfläche mittels Aluminium-Leitbahnen untereinander elektrisch verbundene Halbleiterzonen erzeugt werden.

Die Aluminium-Leitbahnen führen zu am Rand des Einzel-ICs angeordneten Aluminium-Pads. Beim Testen werden auf die Pads harte Spitzen praktisch senkrecht aufgesetzt, die zu federnden, meist schräg zur Oberfläche der Pads gerichteten Kontaktnadeln gehören. Die Kontaktnadeln sind Bestandteil einer Adapteranordnung, die die Kontaktnadeln elektrisch mit einem Meßgerät verbindet. An der Adapteranordnung sind die Kontaktnadeln auf die Pads justierbar gehaltert.

Die Spitzen sind erforderlich, um die an der Oberfläche von Aluminium immer vorhandene Aluminiumoxid-Schicht sicher durchstoßen zu können, da erst dann ein erforderlicher, möglichst niederohmiger Kontakt mit den Pads erreicht wird. Die Adapteranordnung wird zu diesem Zweck solange auf die Pads zu bewegt, bis die schräg gerichteten Kontaktnadeln einen Federdruck auf die Spitzen und die Pads einwirken lassen.

Zur Vermeidung der genannten Kontaktnadeln ist in der WO-A 97/07924 eine zum Testen von noch nicht von einem Silicium-Wafer abgetrennten Einzel-ICs bestimmte Adapteranordnung beschrieben, wobei das Einzel-IC einen ersten, einen zweiten und einen n-ten auch als Testpunkt dienenden Pad aufweist, wobei die Pads an einem Rand des Einzel-ICs nebeneinanderliegen und wobei n eine beliebig vorgebbare ganze Zahl ist, welche Adapteranordnung umfaßt:
- eine als Membran wirkende, mehrschichtige flexible Folie aus Isoliermaterial mit
   -- einer Vorder- und einer Rückseite,
   -- einer an der Vorderseite liegenden Vorderseiten-Schicht,
   -- einer an der Rückseite liegenden Vorderseiten-Schicht,
   -- einer zwischen der Vorderseiten- und der Vorderseiten-Schicht angeordneten Mittelschicht,
   -- einem ersten, einem zweiten und einem n-ten elektrisch leitenden Kontaktbump mit einer Längsachse und einem Kontaktierungsteil, der an seinem Ende harte, spitze Mikrovorsprünge trägt, welcher Kontaktbump
      --- durch die Vorderseiten-Schicht in einer Bohrung, die eine Mittelachse hat, zur Vorderseite senkrecht hindurchführt,
      --- die Vorderseite in zwei Stufen derart überragt,
         ---- daß eine erste Stufe eine seitliche elektrische Verbindung zum Kontaktierungsteil herstellt und
         ---- daß der Kontaktierungsteil gegenüber der Bohrung seitlich versetzt ist,
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- einer den ersten Kontaktbump kontaktierenden, auf einer von der Vorderseite abgewandten Seite der Vorderseiten-Schicht verlaufenden ersten Leiterbahn,
   -- einer den zweiten Kontaktbump kontaktierenden, auf der von der Vorderseite abgewandten Seite der Vorderseiten-Schicht verlaufenden zweiten Leiterbahn und
   -- einer den n-ten Kontaktbump kontaktierenden, auf der von der Vorderseite abgewandten Seite der Vorderseiten-Schicht verlaufenden n-ten Leiterbahn,
      --- von denen die erste Leiterbahn mit einem ersten Kontaktpad, die zweite Leiterbahn mit einem zweiten Kontaktpad und die n-te Leiterbahn mit einem n-ten Kontaktpad dauernd verbunden ist, und
- eine Blattfedervorrichtung,
   -- mit der die Membran über einen Stempel flächig an die Pads gedrückt werden kann und
   -- deren Federkraft einstellbar ist.

Das oben erwähnte Kontaktierungsproblem, eine Aluminiumoxid-Schicht durchstoßen zu müssen, tritt beim Testen von Leiterplatten nicht auf, da bei diesen bekanntlich andere Metalle als Aluminium für die Leiterbahnen, nämlich insb. nickel/gold-, zinn- oder blei/zinn-beschichtetes Kupfer, verwendet werden. Vielmehr ergeben sich beim Testen von Leiterplatten schon aufgrund ihrer gegenüber der Fläche von Einzel-ICs erheblich größeren zu testenden Fläche andere Probleme, die zu lösen sind.

So haben heutige Einzel-ICs eine Fläche von ca. 10 mm mal 10 mm, während Leiterplatten bis zu 400 mm mal 400 mm und mehr groß sein können. Zudem sind Testpunkte, die den erwähnten Pads entsprechen, meist nicht am Rand der Leiterplatte angeordnet, sondern über deren Fläche beliebig verteilt. Auch ist die Anzahl der Testpunkte wesentlich größer als die der Pads von Einzel-ICs.

Ferner sind Leiterplatten aufgrund ihrer großen Flächen über die gesamte Fläche betrachtet erheblich weniger eben als die erwähnten Einzel-ICs und auch nicht verwindungsfrei. Nach einem internationalen Standard (IPC-TM-650; IPC = Institute for Interconnection an Packaging Electronic Circuits) ist nämlich eine Verwölbung und Verwindung (im Englischen: "bow and twist") von kleiner als 1,5 % der längsten Abmessung der Leiterplatte zugelassen.

Das Aufsetzen von Kontaktnadeln auf Leiterplatten zu deren Testen ist daher praktisch unmöglich. Aber auch die zweistufigen Kontaktbumps nach der oben referierten WO-A sind aus den folgenden Gründen ungeeignet.

Wegen der erwähnten Unebenheit von Leiterplatten würden Scherkräfte auf die Kontaktierungsteile der zweistufigen Kontaktbumps einwirken, so daß die ersteren leicht abbrechen könnten. Auch wären wegen der Unebenheit größere Federwege für gleiche Anpreßdrücke an die Leiterplatte als bei der für die sehr gut ebenen Einzel-ICs dimensionierten Adapteranordnung erforderlich.

Eine Aufgabe der Erfindung besteht daher darin, eine zum Testen von, insb. auch großflächigen, Leiterplatten geeignete Adapteranordnung anzugeben, die mit anderen Kontaktbumps als den vorbeschriebenen das Testen möglich macht, insb. wenn die Mitten der Testpunkte nur einen Abstand von etwa 150 µm haben, welcher Wert die Untergrenze dieser Abstände bei heute herstellbaren Leiterplatten darstellt.

Zur Lösung dieser Aufgabe und der geschilderten Probleme besteht eine erste Variante der Erfindung daher in einer Adapteranordnung zum elektrischen Anschluß von zu testenden, mindestens einlagigen, unbestückten Leiterplatten an ein Testgerät, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus Isoliermaterial
   -- mit einer Vorder- und einer Rückseite,
   -- mit einem ersten, einem zweiten und einem n-ten elektrisch leitenden Kontaktbump, der
      --- einen Kontaktierungsteil und eine Längsachse aufweist,
      --- von der Rückseite zur Vorderseite durch die Folie in einer Bohrung, die eine Mittelachse hat, senkrecht hindurchführt,
      --- die Vorderseite einstufig überragt und
      --- derart in der Bohrung sitzt, daß die Längsachse mit deren Mittelachse zusammenfällt, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- mit einem den ersten Kontaktbump kontaktierenden, auf der Rückseite der Folie verlaufenden ersten Leiterzug (im Englischen als conductor bezeichnet),
   -- mit einem den zweiten Kontaktbump kontaktierenden, auf der Rückseite der Folie verlaufenden zweiten Leiterzug,
   -- mit einem den n-ten Kontaktbump kontaktierenden, auf der Rückseite der Folie verlaufenden n-ten Leiterzug,
      --- von denen der erste Leiterzug mit einem ersten Kontaktelement einer Steckverbindung, der zweite Leiterzug mit einem zweiten Kontaktelement der Steckverbindung und der n-te Leiterzug mit einem n-ten Kontaktelement der Steckverbindung zum Anschluß an das Testgerät dauernd verbunden ist, und
- eine elektrisch isolierende, elastisch federnde, mit der Rückseite der Folie mechanisch verbundene Zwischenfolie.

Zur Lösung der oben genannten Aufgabe und der oben geschilderten Probleme besteht eine zweite Variante der Erfindung in einer Adapteranordnung zum elektrischen Anschluß von zu testenden, mindestens einlagigen, unbestückten Leiterplatten an ein Testgerät, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus Isoliermaterial
   -- mit einer Vorder- und einer Rückseite,
   -- mit einem ersten, einem zweiten und einem n-ten elektrisch leitenden Kontaktbump mit einem Kontaktierungsteil und einer Längsachse, welcher Kontaktbump
      --- von der Rückseite zur Vorderseite durch die Folie in einer Bohrung, die eine Mittelachse hat, senkrecht hindurchführt,
      --- die Vorderseite einstufig überragt und
      --- derart in der Bohrung sitzt, daß die Längsachse mit deren Mittelachse zusammenfällt, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- mit einem den ersten Kontaktbump kontaktierenden, auf der Rückseite der Folie verlaufenden ersten Leiterzug,
   -- mit einem den zweiten Kontaktbump kontaktierenden, auf der Rückseite der Folie verlaufenden zweiten Leiterzug,
   -- mit einem den n-ten Kontaktbump kontaktierenden, auf der Rückseite der Folie verlaufenden n-ten Leiterzug,
      --- von denen der erste Kontaktpunkt mit einem ersten Kontaktelement eines Eingangskontaktfelds des Testgeräts, der zweite Kontaktpunkt mit einem zweiten Kontaktelement des Eingangskontaktfelds und der n-te Kontaktpunkt mit einem n-ten Kontaktelement des Eingangskontaktfelds mittels dessen Andrückens an die Rückseite der Folie unter Zwischenlage einer elektrisch isolierenden, elastisch federnden Zwischenfolie elektrisch zu kontaktieren ist,
         ---- die dort, wo ein Kontaktelement einen Kontaktpunkt zu kontaktieren hat, eine elektrische Durchkontaktierung aufweist.

Zur Lösung der oben genannten Aufgabe und der oben geschilderten Probleme besteht eine dritte Variante der Erfindung in einer Adapteranordnung zum elektrischen Anschluß von zu testenden, mindestens einlagigen, unbestückten Leiterplatten an ein Testgerät, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus Isoliermaterial
   -- mit einer Vorder- und einer Rückseite sowie mit einem ersten und einem damit zusammenhängenden zweiten Teil,
   -- mit einem ersten, einem zweiten und einem n-ten elektrisch leitenden Kontaktbump mit einem Kontaktierungsteil und einer Längsachse, welcher Kontaktbump
      --- im ersten Teil der Folie angeordnet ist,
      --- von der Rückseite zur Vorderseite durch die Folie in einer Bohrung, die eine Mittelachse hat, senkrecht hindurchführt,
      --- die Vorderseite einstufig überragt und
      --- derart in der Bohrung sitzt, daß die Längsachse mit deren Mittelachse zusammenfällt, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- mit einem den ersten Kontaktbump kontaktierenden, auf der Rückseite der Folie verlaufenden ersten Leiterzug,
   -- mit einem den zweiten Kontaktbump kontaktierenden, auf der Rückseite der Folie verlaufenden zweiten Leiterzug,
   -- mit einem den n-ten Kontaktbump kontaktierenden, auf der Rückseite der Folie verlaufenden n-ten Leiterzug,
      --- von denen der erste Leiterzug zu einem ersten, im zweiten Teil der Folie liegenden Vorderseiten-Kontaktbump, der zweite Leiterzug zu einem zweiten, im zweiten Teil der Folie liegenden Vorderseiten-Kontaktbump und der n-te Leiterzug zu einem n-ten, im zweiten Teil der Folie liegenden Vorderseiten-Kontaktbump führt, welcher Vorderseiten-Kontaktbump
         ---- von der Rückseite zur Vorderseite durch die Folie in einer metallisierten Bohrung, die eine Mittelachse hat, senkrecht hindurchführt,
         ---- die Vorderseite einstufig überragt,
         ---- derart in der Bohrung sitzt, daß die Längsachse mit deren Mittelachse zusammenfällt, wobei
         ---- der erste Vorderseiten-Kontaktbump mit einem ersten Kontaktelement eines Eingangskontaktfelds des Testgeräts, der zweite Vorderseiten-Kontaktbump mit einem zweiten Kontaktelement des Eingangskontaktfelds und der n-te Vorderseiten-Kontaktbump mit einem n-ten Kontaktelement des Eingangskontaktfelds durch Wenden des zweiten Teils der Folie um ca. 180° und mittels Andrückens des Eingangskontaktfelds an die Vorderseite der Folie im zweiten Teil unter Zwischenlage einer elektrisch isolierenden, elastisch federnden Zwischenfolie zwischen die Rückseite der Folie in deren erstem und zweitem Teil elektrisch zu kontaktieren ist.

Nach einer bevorzugten Ausgestaltung der zweiten Variante der Erfindung sind die Durchkontaktierungen in Form von in Längsrichtung federnden Stiften oder in Form von elastischen leitenden Zylindern realisiert.

Ein Vorteil der Erfindung besteht darin, daß eine speziell für das Testen von Leiterplatten geeignete Adapteranordnung geschaffen wird, die alle an sie zu stellenden Anforderungen erfüllt und leicht mit den in der Leiterplattentechnik üblichen Verfahren herstellbar, also mit dieser Technik kompatibel ist.

Ein weiterer Vorteil ist, daß die Adapteranordnung der Erfindung aufgrund ihres Aufbaus auch bei doppelseitigen Leiterplatten ohne weiteres verwendet werden kann, wie unten noch ausführlich erläutert werden wird.

Die Erfindung und weitere Vorteile werden nun anhand von Ausführungsbeispielen näher erläutert, die in den Figuren der Zeichnung schematisch dargestellt sind; dabei sind Bezugszeichen, die anhand einer bestimmten Figur erläutert wurden, in folgenden Figuren nur noch wenn erforderlich wieder eingetragen.
- Fig. 1: zeigt perspektivisch eine Leiterplatte mit einem einfachen Layout,
- Fig. 2: zeigt perspektivisch eine Adapteranordnung entsprechend einer ersten Variante der Erfindung zusammnen mit der Leiterplatte von Fig. 1,
- Fig. 3: im Schnitt einen Kontaktbump der Adapteranordnung,
- Fig. 4: zeigt perspektivisch eine Anwendung des Prinzips der Adapteranordnung von Fig. 2 bei einer zu testenden Leiterplatte mit sowohl auf deren Oberseite als auch auf deren Unterseite vorhandenen Leiterbahnen,
- Fig. 5: zeigt perspektivisch eine Adapteranordnung entsprechend einer zweiten Variante der Erfindung zusammen mit der Leiterplatte von Fig. 1, und
- Fig. 6: zeigt perspektivisch eine Adapteranordnung entsprechend einer dritten Variante der Erfindung zusammen mit der Leiterplatte von Fig. 1.

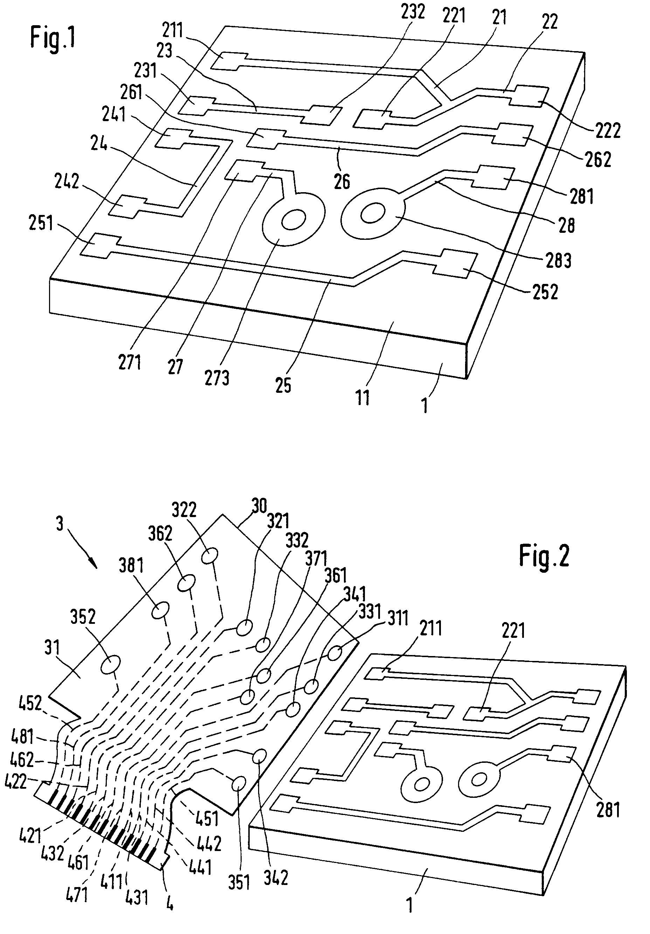

In Fig. 1 ist eine noch nicht mit elektronischen Komponenten bestückte Leiterplatte 1, die im eingangs erwähnten Sinn getestet werden muß, mit einem einfachen Layout perspektivisch gezeigt. Die Leiterplatte 1 hat eine nicht zu sehende Unterseite und eine Oberseite 11 und ist darauf mit acht Leiterbahnen (im Englischen mit "tracks" bezeichnet) 21, 22, 23, 24, 25, 26, 27, 28 versehen.

Die Leiterbahn 21 ist somit eine erste Leiterbahn, die Leiterbahn 22 eine zweite Leiterbahn und die Leiterbahn 28 eine m-te Leiterbahn. Von diesen Leiterbahnen mündet die Leiterbahn 21 in die Leiterbahn 22, während die restlichen miteinander nicht verbundene selbständige Leiterbahnen sind. Es sind somit in Fig. 1 m = 8 Leiterbahnen vorhanden.

Die Leiterbahn 21 ist an ihrem einzigen Ende mit einem ersten Testpunkt 211 und die Leiterbahn 22 an ihrem einen Ende mit einem zweiten Testpunkt 221 versehen. Ein weiterer Testpunkte 222 befindet sich am anderen Ende der Leiterbahn 22; weitere Testpunkte 231, 232; 241, 242; 251, 252; 261, 262 befinden sich an den Enden der Leiterbahnen 23, 24, 25, 26. Die Leiterbahnen 27, 28 haben jeweils nur einen Testpunkt 271, 281; der Testpunkt 281 ist ein n-ter Testpunkt. Alle diese Testpunkte sind in Fig. 1 rechteckig dargestellt. In Fig. 1 sind n = 13 Testpunkte vorhanden.

Ferner sind noch zwei kreisförmige Anschlußflächen 273, 283 gezeigt, über die durch die Leiterplatte hindurch die elektrische Verbindung zu eventuell vorhandenen, nicht zu sehenden Leiterbahnen auf der Unterseite der Leiterplatte 1 hergestellt werden kann. Das ist z.B. durch vom Hersteller der Leiterplatte bereits erzeugte Durchmetallisierungen oder erst vom Anwender der Leiterplatte mittels einer einzulötenden Komponente relisierbar.

An mindestens einem Teil der Testpunkte werden vom Benutzer der Leiterplatte nach deren Auslieferung elektronische Komponenten, wie z.B. MELF- oder MiniMELF-Komponenten angebracht. Die Leiterplatte 1 ist in Fig. 1 einlagig dargestellt, was jedoch nicht zwingend ist.

Die Testpunkte sind während des Testvorgangs mittels einer Adapteranordnung an ein nicht dargestelltes Testgerät anzuschließen, das von üblicher Bauart ist, so daß auf seine Darstellung und Erläuterung hier verzichtet werden kann.

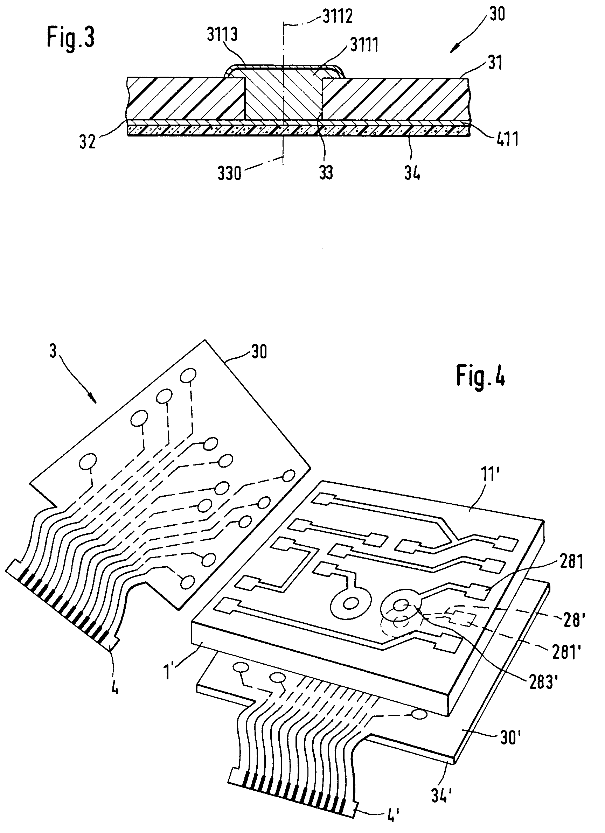

In Fig. 2 ist perspektivisch und zusammen mit der Leiterplatte 1 von Fig. 1 eine erste Variante einer Adapteranordnung 3 dargestellt. Diese umfaßt eine einschichtige flexible Folie 30 aus Isoliermaterial, z.B. aus einem Polyimid, die eine Vorderseite 31 und eine nur in Fig. 3 zu sehende Rückseite 32 hat.

Auf und/oder in der Folie 30 sind ein erster, ein zweiter und ein n-ter elektrisch leitender Kontaktbump 311, 321, 381 angeordnet. Ferner sind zehn weitere Kontaktbumps 322; 331, 332; 341, 342; 351, 352; 361, 362; 371 vorhanden. Die Bezugszeichen der Kontaktbumps sind so gewählt, daß ihre letzten beiden Ziffern den letzten beiden Ziffern der Bezugszeichen der Testpunkte 222; 231, 232; 241, 242; 251, 252; 261, 262; 271 gleich sind.

Alle n = 13 Kontaktbumps sind auf der Vorderseite 31 der Folie 30 genau spiegelbildlich zu der flächenmäßigen Anordnung der n = 13 Testpunkte auf der Leiterplatte 1 angeordnet. Wenn während des Testens die Vorderseite 31 der Folie 3 mit der Oberseite 11 der Leiterplatte 1 durch Auflegen mechanisch in Berührung gebracht und nach einem entsprechenden Ausrichten flächig, z.B. mittels eines Stempels, daran angedrückt wird, kontaktieren die "zueinander gehörenden" Kontaktbumps "ihre" Testpunkte elektrisch.

Auf der Rückseite der Folie 30 ist der erste Kontaktbump 311 mittels eines ersten Leiterzugs 411 (im Englischen mit "conductor" bezeichnet) mit einem ersten Kontakt einer Steckverbindung 4 elektrisch verbunden. Da der Leiterzug 411 - wie auch die übrigen noch zu erläutertenden Leiterzüge - auf der Rückseite der Folie 30 angeordnet ist, ist sein Verlauf gestrichelt gezeichnet.

Auf der Rückseite der Folie 30 ist der zweite Kontaktbump 321 mittels eines zweiten Leiterzugs 421 mit einem zweiten Kontakt der Steckverbindung 4 kontaktiert. In vergleichbarer Weise sind die Kontaktbumps 322, 331, 332, 341, 342, 351, 352, 361, 362, 371, 381 mittels Leiterzügen 422, 431, 432, 441, 442, 451, 452, 461, 462, 471, 481 mit einem entsprechenden Kontakt der Steckverbindung 4 kontaktiert. Der Leiterzug 481 ist somit ein n-ter Leiterzug.

Die Bezugszeichen der Leiterzüge sind so gewählt, daß ihre letzten beiden Ziffern den letzten beiden Ziffern der Bezugszeichen der Testpunkte 211, 221 222, 231, 232, 241, 242, 251, 252, 261, 262, 271, 281 und der Kontaktbumps 311, 321, 322, 331, 332, 341, 342, 351, 352, 361, 362, 371, 381 gleich sind.

Die Fig. 3 zeigt den Aufbau der Kontaktbumps im Schnitt und stark vergrößert, und zwar anhand des Kontaktbumps 311 von Fig. 2. Der Kontaktbump hat einen Kontaktierungsteil 3111 sowie eine Längsachse 3112. Er führt senkrecht von der Rückseite 32 zur Vorderseite 31 durch die Folie 30 in einer Bohrung 33 hindurch, die eine Mittelachse 330 hat.

Üblicherweise wird ein derartiger Kontaktbump dadurch in der Bohrung 33 erzeugt, daß darin, ausgehend vom an der Rückseite 32 vorhandenen Leiterzug 411, galvanisch oder außenstromlos Kupfer über den Rand an der Vorderseite 31 der Bohrung 33 hinaus wachsen gelassen wird. Dadurch bildet sich ein Kontaktierungsteil 3111, der die Vorderseite 31 einstufig überragt und derart in der Bohrung 33 sitzt, daß die Längsachse 3112 mit der Mittelachse 330 zusammenfällt. Die Oberfläche des Kontaktierungsteils 3111 ist mit einer Nickel-Gold-Schicht 3113 plattiert.

In Fig. 3 ist ferner wegen der besseren Darstellbarkeit als in Fig. 2 gezeigt, daß eine elektrisch isolierende, elastisch federnde Zwischenfolie 34 an der Rückseite 32 der Folie 30 angeordnet ist, die dort z.B. mechanisch fest verbunden sein und z.B. aus einem geeigneten Schaumstoff bestehen kann. Somit schmiegt sich die Folie 30 beim erwähnten Andrücken während des Testens sehr gut an die Leiterplatte 1 an, selbst wenn diese recht uneben sein sollte.

Die Fig. 4 zeigt perspektivisch, daß das Prinzip der Adapteranordnung von Fig. 2 auch bei zu testenden Leiterplatten mit sowohl auf deren Oberseite als auch auf deren Unterseite vorhandenen Leiterbahnen angewendet werden kann.

In Fig. 4 ist eine noch nicht mit elektronischen Komponenten beidseits bestückte Leiterplatte 1', die im eingangs erwähnten Sinn getestet werden muß, mit einem einfachen Layout auf der Oberseite 11' perspektivisch gezeigt, das der zeichnerischen Einfachheit halber mit dem Layout der Leiterplatte 1 der Fig. 1 und 2 identisch ist.

Die Leiterplatte 1' hat auch auf der nicht zu sehenden Unterseite Leiterbahnen, von denen lediglich die Leiterbahn 28' gezeigt ist, und zwar gestrichelt. Sie führt einerseits zur Anschlußfläche 283' und andererseits zum Testpunkt 281'.

In Fig. 4 ist zusätzlich zur Folie 30 eine weitere Folie 30' zu sehen, die an der Rückseite der Leiterplatte 1' angeordnet ist. Der prinzipielle Aufbau der Folie 30' ist mit dem der Folie 30 identisch. So ist eine Steckverbindung 4' zum Anschluß an das Testgerät vorhanden. Allerdings wird i.a. das Layout der Leiterbahnen von dem der Folie 30 abweichen.

In vergleichbarer Weise wie bei der Adapteranordnung der Fig. 2 und 3 ist eine weitere elektrisch isolierende, elastisch federnde Zwischenfolie 34', z.B. aus einem Schaumstoff, an der Rückseite der Folie 30' angeordnet, die dort z.B. mechanisch fest verbunden sein kann. Somit schmiegt sich die Folie 30' beim erwähnten Andrücken während des Testens ebenfalls sehr gut an die Unterseite der Leiterplatte 1' an.

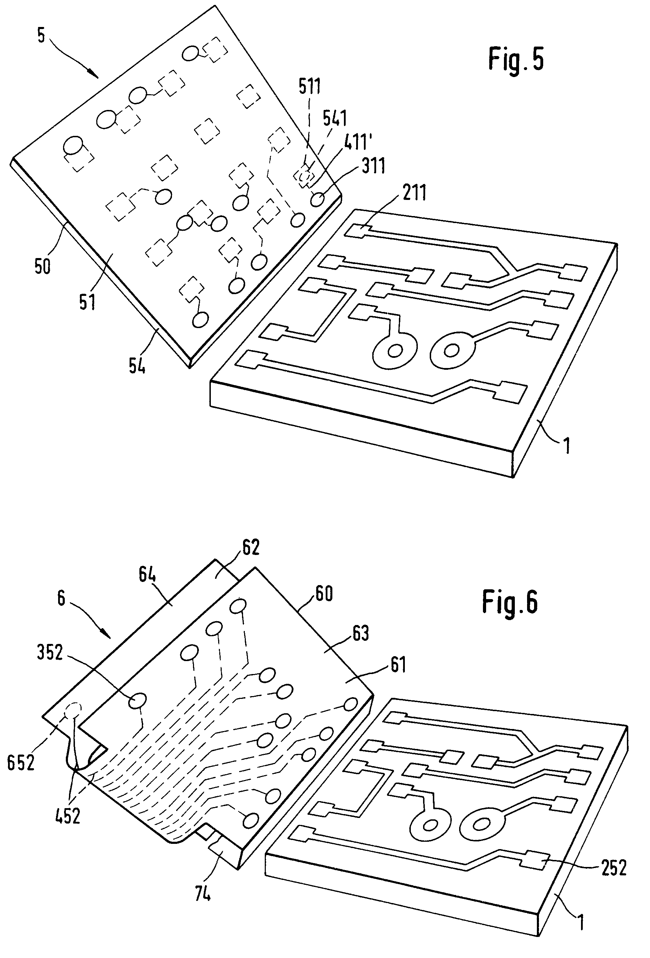

Die Fig. 5 zeigt perspektivisch eine Adapteranordnung 5 entsprechend einer zweiten Variante der Erfindung zusammnen mit der Leiterplatte 1 von Fig. 1. Die Adapteranordnung 5 ist im wesentlichen eine einschichtige flexible Folie 50 aus Isoliermaterial mit einer Vorderseite 51, auf der Kontaktbumps wie bei der Folie 30 von Fig. 2 angeordnet sind; auf der Rückseite sind also wiederum Leiterbahnen vorgesehen, die mit den einzelnen Kontaktbumps elektrisch verbunden sind. So gehört z.B. der Kontaktbump 311 zu einer Leiterbahn 411', deren Verlauf von dem der Leiterbahn 411 in Fig. 2 allerdings abweicht.

Dies nämlich deshalb, weil bei der zweiten Variante der Erfindung jede Leiterbahn mit einem zugehörigen Kontaktelement eines Eingangskontaktfelds des Testgeräts elektrisch zu kontaktieren ist, wobei die Leiterbahnen am Ort der Kontaktelemente Kontaktpunkte aufweisen; z.B. gehört zum Kontaktbump 311 und der Leiterbahn 411' der Kontaktpunkt 511.

Das Kontaktieren geschieht dadurch, daß das Eingangskontaktfeld an die Rückseite der Folie 50 unter Zwischenlage einer elektrisch isolierenden, elastisch federnden Zwischenfolie 54 angedrückt wird. Diese weist dort, wo ein Kontaktelement einen Kontaktpunkt zu kontaktieren hat, eine elektrische Durchkontaktierung 541 auf. Diese Durchkontaktierungen können bevorzugt mittels in Längsrichtung federnden Stiften oder mittels elastischen leitenden Zylindern realisiert werden.

Das in Fig. 5 der Einfachheit halber nicht dargestellte Eingangskontaktfeld des Testgeräts hat eine in Zeilen und Spalten regelmäßige Anordnung der erwähnten Kontaktelemente. Zu dieser Anordnung spiegelbildlich ist die fächenmäßige Verteilung der Kontaktpunkte, zu denen der Kontaktpunkt 511 gehört.

Auch die zweite Variante der Erfindung kann zusammen mit zweiseitigen Leiterplatten in mit Fig. 4 vergleichbarer Weise angewendet werden. In diesem Fall ist für die Rückseite der zweiseitigen Leiterplatte eine der Adapteranordnung 5 entsprechende weitere Adapteranordnung vorzusehen. Diese ist beim Testen mittels einer der Zwischenfolie 54 entsprechenden weiteren Zwischenfolie an das Eingangskontaktfeld des Testgeräts anzudrücken.

Die Fig. 6 zeigt perspektivisch eine Adapteranordnung 6 entsprechend einer dritten Variante der Erfindung zusammnen mit der Leiterplatte von Fig. 1. Die Adapteranordnung 6 ist im wesentlichen eine einschichtige flexible Folie 60 aus Isoliermaterial mit einer Vorderseite 61 und einer Rückseite 62 sowie mit einem ersten Teil 63 und einem damit zusammenhängenden zweiten Teil 64.

Auf der Vorderseite 61 sind im ersten Teil 63 wie bei der Folie 30 von Fig. 2 Kontaktbumps zur Kontaktierung der Testpunkte der Leiterplatte 1 vorgesehen. Auf der Rückseite 62 sind wieder Leiterzüge vorgesehen, die mit den einzelnen Kontaktbumps elektrisch verbunden sind. So gehört z.B. der Kontaktbump 352 zum Leiterzug 452 und zum Testpunkt 252.

Die Leiterzüge erstrecken sich auch in den zweiten Teil 64 der Folie 60 und enden dort in zugehörigen Vorderseiten-Kontaktbumps; von diesen ist in Fig. 6 nur der zum Kontaktbump 352 gehörende Vorderseiten-Kontaktbump 652 dargestellt.

Jeder Vorderseiten-Kontaktbump ist genauso aufgebaut, wie es in Fig. 3 dargestellt ist. Er führt also von der Rückseite 62 zur Vorderseite 61 senkrecht durch die Folie 60 in einer Bohrung hindurch, die eine Mittelachse hat. Ferner überragt er die Vorderseite 61 einstufig und sitzt derart in der Bohrung, daß die Längsachse mit deren Mittelachse zusammenfällt.

Beim Testen werden die einzelnen Vorderseiten-Kontaktbumps mit einem einzelnen entsprechenden Kontaktelement des bereits in Zusammenhang mit Fig. 5 erwähnten Eingangskontaktfelds des Testgeräts elektrisch kontaktiert. Daher ist die fächenmäßige Verteilung der Vorderseiten-Kontaktbumps auch hier spiegelbildlich zur Anordnung der Kontaktelemente.

Das Kontaktieren erfolgt, indem der zweite Teil 64 der Folie 60 um ca. 180° gewendet wird und indem das Eingangskontaktfeld an die Vorderseite 61 der Folie 60 im zweiten Teil 64 angedrückt, und zwar unter Zwischenlage einer elektrisch isolierenden, elastisch federnden Zwischenfolie 74 zwischen den ersten Teil 63 und den zweiten Teil 64 der Rückseite 62 der Folie 60.

Die Zwischenfolie 74 ist in Fig. 6 nur teilweise dargestellt, damit sie andere Figurenteile nicht überdeckt. Bei der Adapteranordnung 6 übt die Zwischenfolie 74 ihre Unebenheiten ausgleichende Funktion sowohl auf den ersten Teil 63 und die Leiterplatte 1 als auch auf den zweiten Teil 64 und das Eingangskontaktfeld aus.

Auch die dritte Variante der Erfindung nach Fig. 6 kann zusammen mit zweiseitigen Leiterplatten in mit Fig. 4 oder Fig. 5 vergleichbarer Weise angewendet werden. Hierbei ist für die Rückseite der zweiseitigen Leiterplatte eine der Adapteranordnung 6 entsprechende weitere, zweiteilige Adapteranordnung vorzusehen. Diese ist beim Testen durch 180°-Wenden und mittels einer der Zwischenfolie 74 entsprechenden weiteren Zwischenfolie an das Eingangskontaktfeld des Testgeräts anzudrücken.

Folgende Materialien werden bei der Erfindung bevorzugt verwendet:
- Handelsübliche Polyimidfolie als Material der Folien ,
- Kupfer-Folie als Material der Leiterbahnen,
- galvanisch oder außenstromlos abgeschiedenes Kupfer als Metallisierung der Füllung der Bohrungen,
- galvanisch oder außenstromlos abgeschiedenes Nickel/Gold als Material der Kontaktbumps,
- handelsübliche nichtleitende Polymerfolien als Material der Zwischenfolien,
- handelsübliche gefederte Stifte oder flexible Zylinder aus elektrisch leitfähigen elastischen Polymeren als Material der Durchkontaktierungen entsprechend Fig. 4. Folgende Herstellungsverfahren werden bei der Erfindung bevorzugt verwendet:
- Strukturieren der Bohrungen mittels üblichem Plasmaätzen oder Laserbohren oder Photolithographie,
- Strukturieren der Kontaktbumps und der Leiterbahnen mittels Photolithographie und galvanisch oder außenstromloser Metallisierung.

## Patentansprüche

1. Adapteranordnung (3) zum elektrischen Anschluß von zu testenden, mindestens einlagigen, unbestückten Leiterplatten (1), an ein Testgerät, die einen ersten, einen zweiten und einen n-ten Testpunkt (211, 221, 281) aufweisen, wobei n eine beliebig vorgebbare ganze Zahl ist, welche Adapteranordnung umfaßt:
- eine einschichtige flexible Folie (30) aus Isoliermaterial
-- mit einer Vorderseite (31) und einer Rückseite,
-- mit einem ersten, einem zweiten und einem n-ten elektrisch leitenden Kontaktbump (311, 321, 381) mit einem Kontaktierungsteil (3111) und einer Längsachse (3112), welcher Kontaktbump
--- von der Rückseite zur Vorderseite durch die Folie in einer Bohrung (33), die eine Mittelachse (330) hat, senkrecht hindurchführt,
--- die Vorderseite einstufig überragt und
--- derart in der Bohrung sitzt, daß die Längsachse mit der Mittelachse zusammenfällt, und
--- von welchen Kontaktbumps während des Testens der erste Kontaktbump (311) mit dem ersten Testpunkt (211), der zweite Kontaktbump (321) mit dem zweiten Testpunkt (221) und der n-te Kontaktbump (381) mit dem n-ten Testpunkt (281) durch flächiges Andrücken der Folie (30) an die Leiterplatte (1) mechanisch in Berührung zu bringen und dadurch elektrisch zu kontaktieren ist,
-- mit einem den ersten Kontaktbump (311) kontaktierenden, auf der Rückseite der Folie verlaufenden ersten Leiterzug (411) ,
-- mit einem den zweiten Kontaktbump (321) kontaktierenden, auf der Rückseite der Folie verlaufenden zweiten Leiterzug (421),
-- mit einem den n-ten Kontaktbump (381) kontaktierenden, auf der Rückseite der Folie verlaufenden n-ten Leiterzug (481),
--- von denen der erste Leiterzug mit einem ersten Kontaktelement einer Steckverbindung (4), der zweite Leiterzug mit einem zweiten Kontaktelement der Steckverbindung und der n-te Leiterzug mit einem n-ten Kontaktelement der Steckverbindung zum Anschluß an das Testgerät dauernd verbunden ist, und
- eine elektrisch isolierende, elastisch federnde, an der Rückseite der Folie angeordnete Zwischenfolie (34) (Fig. 2 bis 4).

2. Adapteranordnung (5) zum elektrischen Anschluß von zu testenden, mindestens einlagigen, unbestückten Leiterplatten (1) an ein Testgerät, die einen ersten, einen zweiten und einen n-ten Testpunkt (211) aufweisen, wobei n eine beliebig vorgebbare ganze Zahl ist, welche Adapteranordnung umfaßt:
- eine einschichtige flexible Folie (50) aus Isoliermaterial
-- mit einer Vorderseite (51) und einer Rückseite,
-- mit einem ersten, einem zweiten und einem n-ten elektrisch leitenden Kontaktbump (311) mit einem Kontaktierungsteil und einer Längsachse, welcher Kontaktbump
--- von der Rückseite zur Vorderseite durch die Folie in einer Bohrung, die eine Mittelachse hat, senkrecht hindurchführt,
--- die Vorderseite einstufig überragt und
--- derart in der Bohrung sitzt, daß die Längsachse mit deren Mittelachse zusammenfällt, und
--- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
-- mit einem den ersten Kontaktbump kontaktierenden, auf der Rückseite der Folie zu einem ersten Kontaktpunkt (511) verlaufenden ersten Leiterzug (411'),
-- mit einem den zweiten Kontaktbump kontaktierenden, auf der Rückseite der Folie zu einem zweiten Kontaktpunkt verlaufenden zweiten Leiterzug,
-- mit einem den n-ten Kontaktbump kontaktierenden, auf der Rückseite der Folie zu eienm n-ten Kontaktpunkt verlaufenden n-ten Leiterzug,
--- von denen der erste Kontaktpunkt (511) mit einem ersten Kontaktelement eines Eingangskontaktfelds des Testgeräts, der zweite Kontaktpunkt mit einem zweiten Kontaktelement des Eingangskontaktfelds und der n-te Kontaktpunkt mit einem n-ten Kontaktelement des Eingangskontaktfelds mittels dessen Andrückens an die Rückseite der Folie (50) unter Zwischenlage einer elektrisch isolierenden, elastisch federnden Zwischenfolie (54) elektrisch zu kontaktieren ist,
---- die dort, wo ein Kontaktelement einen Kontaktpunkt zu kontaktieren hat, eine elektrische Durchkontaktierung aufweist (Fig. 5).

3. Adapteranordnung (6) zum elektrischen Anschluß von zu testenden, mindestens einlagigen, unbestückten Leiterplatten (1) an ein Testgerät, die einen ersten, einen zweiten und einen n-ten Testpunkt (252) aufweisen, wobei n eine beliebig vorgebbare ganze Zahl ist, welche Adapteranordnung umfaßt:
- eine einschichtige flexible Folie (60) aus Isoliermaterial
-- mit einer Vorder- und einer Rückseite (61 bzw. 62) sowie mit einem ersten und einem damit zusammenhängenden zweiten Teil (63 bzw. 64),
-- mit einem ersten, einem zweiten und einem n-ten elektrisch leitenden Kontaktbump mit einem Kontaktierungsteil und einer Längsachse, welcher Kontaktbump
--- im ersten Teil der Folie angeordnet ist,
--- von der Rückseite zur Vorderseite durch die Folie in einer Bohrung, die eine Mittelachse hat, senkrecht hindurchführt,
--- die Vorderseite einstufig überragt und
--- derart in der Bohrung sitzt, daß die Längsachse mit deren Mittelachse zusammenfällt, und
--- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
-- mit einem den ersten Kontaktbump kontaktierenden, auf der Rückseite der Folie verlaufenden ersten Leiterzug,
-- mit einem den zweiten Kontaktbump kontaktierenden, auf der Rückseite der Folie verlaufenden zweiten Leiterzug,
-- mit einem den n-ten Kontaktbump kontaktierenden, auf der Rückseite der Folie verlaufenden n-ten Leiterzug,
--- von denen der erste Leiterzug zu einem ersten, im zweiten Teil der Folie liegenden Vorderseiten-Kontaktbump, der zweite Leiterzug zu einem zweiten, im zweiten Teil der Folie liegenden Vorderseiten-Kontaktbump und der n-te Leiterzug zu einem n-ten, im zweiten Teil der Folie liegenden Vorderseiten-Kontaktbump führt, welcher Vorderseiten-Kontaktbump
---- von der Rückseite zur Vorderseite durch die Folie in einer Bohrung, die eine Mittelachse hat, senkrecht hindurchführt,
---- die Vorderseite einstufig überragt,
---- derart in der Bohrung sitzt, daß die Längsachse mit deren Mittelachse zusammenfällt, wobei
---- der erste Vorderseiten-Kontaktbump mit einem ersten Kontaktelement eines Eingangskontaktfelds des Testgeräts, der zweite Vorderseiten-Kontaktbump mit einem zweiten Kontaktelement des Eingangskontaktfelds und der n-te Vorderseiten-Kontaktbump mit einem n-ten Kontaktelement des Eingangskontaktfelds durch Wenden des zweiten Teils der Folie um ca. 180° und mittels Andrückens des Eingangskontaktfelds an die Vorderseite der Folie im zweiten Teil unter Zwischenlage einer elektrisch isolierenden, elastisch federnden Zwischenfolie (74) zwischen die Rückseite der Folie in deren erstem und zweitem Teil elektrisch zu kontaktieren ist (Fig. 6).

4. Adapteranordnung nach Anspruch 2, bei der die Durchkontaktierungen in Form von in Längsrichtung federnden Stiften oder in Form von elastischen leitenden Zylindern realisiert sind.
